(19) Europäisches Patentamt

European Patent Office

Office européen des brevets

(11) EP 1 617 558 A1

(12) EUROPEAN PATENT APPLICATION

(43) Date of publication:
18.01.2006 Bulletin 2006/03

(51) Int Cl.:
*H03F 1/14* (2006.01)  *H03F 1/56* (2006.01)

(21) Application number: 04425518.0

(22) Date of filing: 13.07.2004

(84) Designated Contracting States:
AT BE BG CH CY CZ DE DK EE ES FI FR GB GR HU IE IT LI LU MC NL PL PT RO SE SI SK TR
Designated Extension States:
AL HR LT LV MK

(71) Applicant: STMicroelectronics S.r.l.
20041 Agrate Brianza MI (IT)

(72) Inventors:
• Scuderi, Antonino
95045 Misterbianco (IT)

• Carrara, Francesco
95024 Acireale (IT)
• Palmisano, Giuseppe
95030 San Giovanni La Punta (IT)

(74) Representative: Pellegri, Alberto et al
c/o Società Italiana Brevetti S.p.A.
Piazza Repubblica, 5
21100 Varese (IT)

(54) **High frequency transistor having an impedance transforming network**

(57)    A common emitter high frequency amplifier that has a larger gain than that of a classic common emitter amplifier using the same components is disclosed. Moreover, the gain does not depend strongly from the parasitic inductance $L_E$, thus a smaller layout may be used.

The known common emitter amplifiers tends to maximize the base voltage. By contrast, this amplifier is realized such to maximize the base-emitter voltage for having the largest possible gain. This objective is reached by connecting a matching capacitor between the high frequency input node of the amplifier and the emitter of the transistor.

FIG. 5

EP 1 617 558 A1

**Description**

FIELD OF THE INVENTION

This invention relates to high frequency amplifier and more particularly to a high frequency common emitter amplifier relatively insensible to the presence of parasitic emitter inductances.

BACKGROUND OF THE INVENTION

High frequency amplifiers are widely used in many high frequency devices, such as LNA, Mixers, Variable Gain Amplifiers etc. when it is necessary to increase the total gain of the device.

Well known high frequency amplifiers are shown in Figures 1a to 4.

The so-called cascode amplifier is depicted in Figure 1a. This amplifier has a high output impedance, which allows a high gain at low frequency. Unfortunately, at high frequency working conditions, parasitic capacitances, in particular the capacitance on the node A, strongly limit the gain of the amplifier.

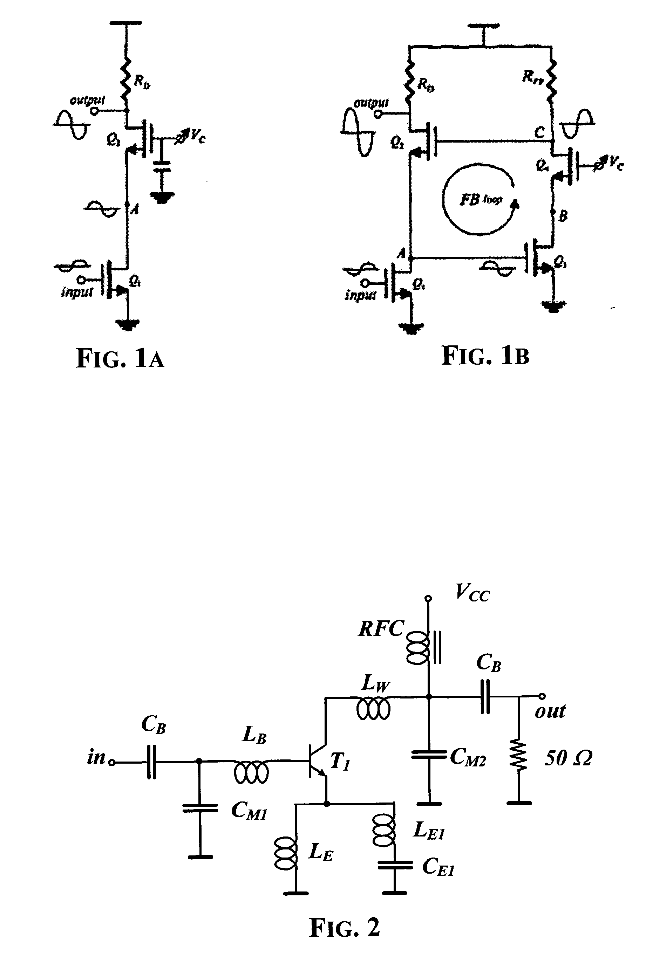

Figure 1b shows the high frequency amplifier disclosed in the article by Kwang-Jin Koh, Yong-Sik You, Hyun-Kyu Yu "A gain boosting method at RF frequency using active feedback and its application to RF variable gain amplifier (VGA)," Circuits and Systems 2002, ISCAS 2002, IEEE International Symposium on, Volume: 3, pages: III-89 - III-92.

This amplifier has an active feedback loop that changes the working conditions of transistor Q2 from a common gate functioning mode to a common source functioning mode, thus increasing the gain. The signal is amplified by the loop composed of the transistors Q1, Q3, Q4, Q2. The low impedance on the node A is used for increasing the gain of the amplifier. Indeed, the value of the resistor $R_{FB}$ is chosen for reducing further this impedance, making the transistor Q2 work in a common source configuration.

This topology cannot be used for realizing very high frequency amplifiers (for instance for WLAN applications at 5 GHz) because a high loop gain with a bandwidth too large for the present technologies (larger than 50 GHz) would be needed.

The amplifier of Figure 1b, even at frequencies that cannot be considered very high, has many drawbacks due to the use of active components. Indeed, power consumption and occupied silicon area of the amplifier are doubled. Output swing of the output signal is reduced because of the cascode architecture, and the amplifier is sensible to parasitic capacitances eventually present on the sources of the transistors Q1 and Q3, which are the main causes of gain reduction especially at high frequency.

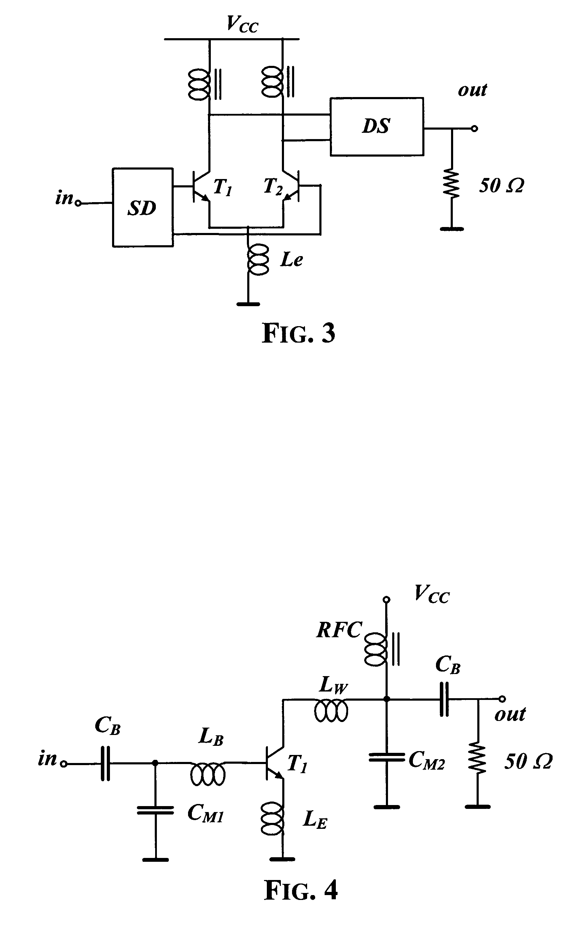

Figure 2 shows the classic single-ended common emitter topology, wherein the parasitic emitter inductance $L_E$ and the network $L_{E1}$-$C_{E1}$ for increasing the gain of the circuit are represented. This architecture solves the drawbacks due to the parasitic emitter inductance $L_E$ because the series resonating filter $L_{E1}$-$C_{E1}$ short-circuits the emitter of the transistor $T_1$ at a frequency determined by the parasitic inductance $L_E$ in parallel with the series resonating filter $L_{E1}$-$C_{E1}$.

A drawback of this solution consists in the difficulty of predicting the values of the inductances $L_E$ and $L_{E1}$. Moreover, the resonating series filter $L_{E1}$-$C_{E1}$ has a relatively narrow bandwidth and is extremely sensitive to fabrication spread.

Figure 3 shows a classic differential topology for a high frequency amplifier. The gain of this amplifier is independent on the emitter parasitic inductance $L_E$.

The depicted architecture is more robust than single-ended architectures, but only when the amplifier is working linearly. In nonlinear working conditions, one of the two transistors tends to turn off when the other is on, and the advantages of the differential topology are jeopardized. Moreover, the differential topology needs a first network for transforming single-ended signals in differential signals and a second network for transforming differential signals in single-ended signals. Often these networks cause unacceptable losses.

Figure 4 shows a classic common emitter high frequency amplifier. This amplifier is composed of a common emitter transistor $T_1$, which in the shown example is a BJT but could be also a MOS transistor, an input network composed of an inductance $L_B$ and a capacitor $C_{M1}$, and an output impedance matching network, which in the shown example is composed of two inductors $L_W$ and RFC and a capacitor $C_{M2}$. The blocking capacitors $C_B$ filter a signal to be amplified IN and the corresponding output signal OUT from their DC components.

In order to maximize the gain of the amplifier of Figure 4 it would be necessary to ground directly the emitter of the transistor $T_1$, but the parasitic inductance $L_E$ due to the connection of the emitter of the transistor $T_1$ to ground cannot be neglected. Typically, this parasitic inductance ranges between 0.1 nH and 0.5 nH.

The lossless impedance matching input ($C_{M1}$, $L_B$) and output ($L_W$, $C_{M2}$, RFC) networks are used for transferring power from a power generator with an output impedance of 50 Ω to the transistor $T_1$, and from transistor $T_1$ to a load of 50 Ω for maximizing the gain of the circuit.

Using a transistor $T_1$ with a cut-off frequency $f_t$ of about 30 GHz, a parasitic inductance of 0.1 nH, at a working frequency of 5.4 GHz and when the input and output impedances are matched, the amplifier of Figure 4 has a gain of 7 dB, which is unsatisfactory.

Moreover the gain of this amplifier reduces rapidly when the inductance becomes larger. Indeed, the gain of the amplifier is

$$\frac{V_{out}}{V_{in}} \cong -\frac{g_m \cdot Z_L}{A_1}$$

wherein $V_{in}$ is the voltage to be amplified on the input high frequency node, $V_{out}$ is the corresponding output voltage on the output node, $Z_L$ is the load impedance from the collector node of the transistor $T_1$, $g_m$ is the transconductance of the transistor $T_1$, and $A_1$ is the transfer function between the input high frequency signal $V_{in}$ and the intrinsic base-emitter voltage $V_\pi$ of the transistor. $A_1$ is given by the following equation

$$A_1 = 1 + \frac{Z_{L_B}}{Z_\pi} + Z_{L_E} \cdot \left( g_m + \frac{1}{Z_\pi} \right)$$

wherein $Z_{LB}$ is the impedance of the inductor $L_B$, $Z_{LE}$ is the impedance of the parasitic inductance $L_E$ and $Z_\pi$ is the base-emitter impedance.

SUMMARY OF THE INVENTION

This invention provides a common emitter high frequency amplifier that has a larger gain than that of a classic common emitter amplifier using the same components. Moreover, the gain does not depend strongly from the parasitic inductance $L_E$, thus a smaller layout may be used.

It has been noticed that the known common emitter amplifiers tends to maximize the base voltage. By contrast, the amplifier of this invention is realized such to maximize the base-emitter voltage for having the largest possible gain. This objective is reached by connecting a matching capacitor between the high frequency input node of the amplifier and the emitter of the transistor.

More precisely, this invention provides a common emitter single transistor high frequency amplifier, having:

- an input inductance between the base of the transistor and a high frequency input node on which a high frequency signal to be amplified is applied, and
- an output impedance matching network between the collector of the transistor and an output node of the amplifier on which an amplified signal is output.

The amplifier of this invention has a larger gain and is less sensitive to the parasitic inductance toward ground than the known common emitter amplifier, because it has a matching capacitor connected between the emitter of the transistor and the high frequency input node of the amplifier.

The invention is defined in the annexed claims.

BRIEF DESCRIPTION OF THE DRAWINGS

The different aspects and advantages of the invention will be even more evident through a detailed description referring to the attached drawings, wherein:

**Figure 1a** shows a cascode amplifier;
**Figure 1b** shows an active feedback amplifier;
**Figure 2** shows a common emitter amplifier with an emitter filter;
**Figure 3** shows a differential amplifier;
**Figure 4** shows a basic common emitter amplifier;
**Figure 5** shows the amplifier of this invention having a matching capacitor connected between an high frequency input node of the amplifier and the emitter of the transistor;
**Figure 6** shows a sample output voltage when the amplifier is operating in small signal conditions;

**Figure 7** shows a sample output voltage when the amplifier is operating in large signal conditions;
**Figure 8** is a diagram of a gain - frequency characteristic of the amplifier of Figure 5;
**Figure 9** is a diagram of the gain - emitter parasitic impedance of the amplifier of Figure 5;
**Figure 10** is a diagram of the gain - matching capacitor impedance of the amplifier of Figure 5.

DESCRIPTION OF THE INVENTION

A preferred embodiment of the high frequency amplifier of this invention is depicted in Figure 5. In the shown embodiment, the transistor $T_1$ is a BJT, but also a MOS transistor could be used.

The intrinsic base-emitter voltage of the transistor $T_1$ must be maximized for having the largest possible gain, and not the base voltage of the transistor $T_1$. According to the invention, the base-emitter voltage is maximized by connecting a matching capacitor $C_{M1}$ between the high frequency input node of the amplifier and the emitter of the transistor $T_1$.

The loop $C_{M1}$-$L_B$ has a boost effect on the intrinsic base-emitter voltage of the transistor, and thus on the gain. This effect makes the gain of the amplifier relatively insensible from the value of the parasitic inductance, which can be increased without reducing significantly the gain.

Comparing the amplifier of this invention and the common emitter amplifier of Figure 4 at the same working frequency and after having matched the input and output impedances, the amplifier of Figure 5 has a gain of 17 dB while the known amplifier of Figure 4 has a gain of only 7 dB.

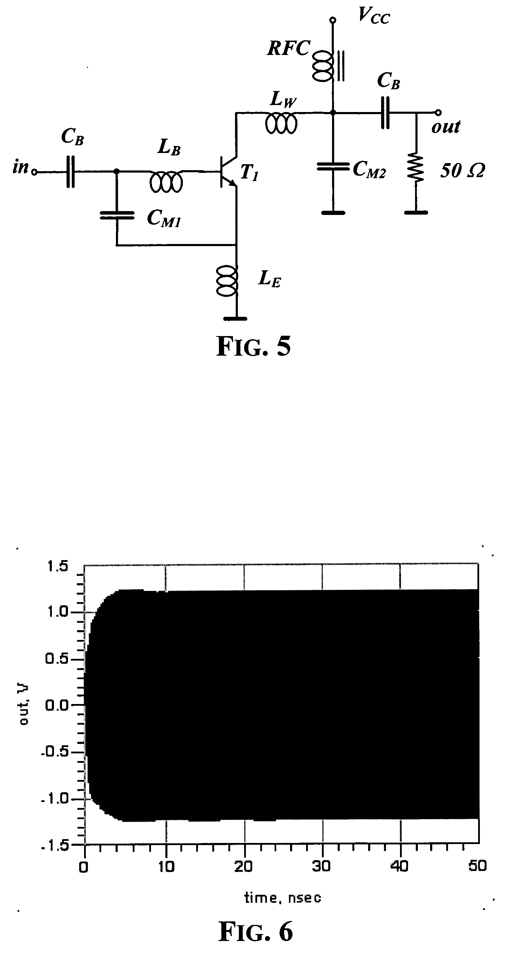

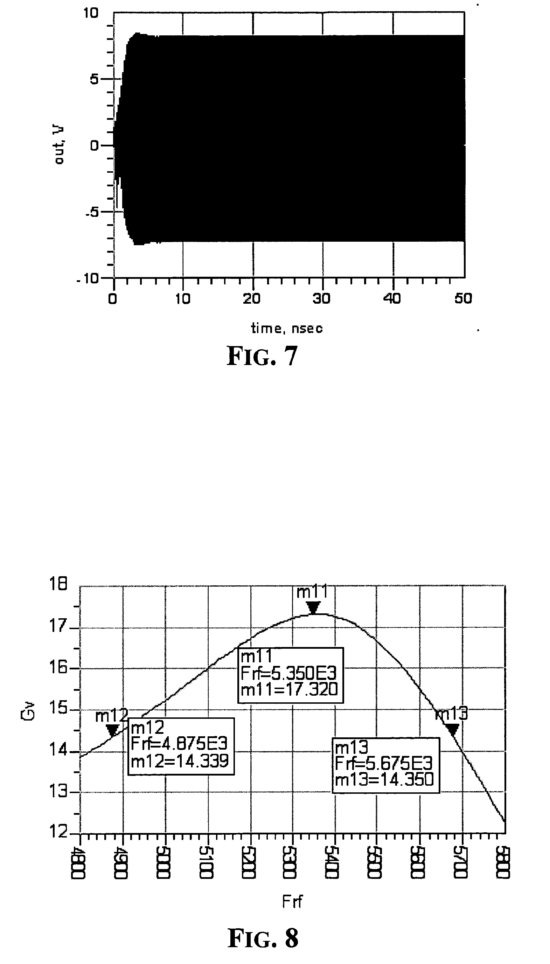

Diagrams of simulations of the amplifier of the invention in small signal and large signal operating conditions are shown in Figures 6 and 7, respectively. From these figures it is possible to notice that the amplitude of the output signals becomes stable after a short transient.

The amplifier of Figure 5 has a larger gain because the gain is given by:

$$\frac{V_{out}}{V_{in}} \cong -\frac{g_m \cdot Z_L}{A_1^*}$$

The transfer function $A_1^*$ between the input high frequency signal $V_{in}$ and the intrinsic base-emitter voltage $V_\pi$ of the transistor of the amplifier is given by the following equation:

$$A_1^* = 1 + \frac{Z_{L_B}}{Z_\pi} + Z_{L_E} \cdot \left( g_m + \frac{1}{Z_\pi} \right) + \frac{Z_{L_E}}{Z_{C_{M1}}} \cdot \left( 1 + \frac{Z_{L_B}}{Z_\pi} \right) = A_1 + \frac{Z_{L_E}}{Z_{C_{M1}}} \cdot \left( 1 + \frac{Z_{L_B}}{Z_\pi} \right)$$

being $Z_{CM1}$ the impedance of the matching capacitor $C_{M1}$.

The gain is maximized when the absolute value of $A_1^*$ is minimum. When $\omega \cdot L_B > (\omega \cdot C_\pi)^{-1}$, being $\omega$ the angular frequency of an input signal, the real part of $A_1$ is negative while the quantity

$$\frac{Z_{L_E}}{Z_{C_{M1}}} \cdot \left( 1 + \frac{Z_{L_B}}{Z_\pi} \right)$$

is positive. Therefore the module of $A_1^*$ is smaller than the module of $A_1$, and the gain of the amplifier of Figure 5 is larger than that of Figure 4.

It is possible to show that when $\omega \cdot L_B > (\omega \cdot C_\pi)^{-1}$ there is a value of $C_{M1}$ for which the real part of $A_1^*$ is null.

In these conditions the gain does not tend to infinity because it is limited by the imaginary part of $A_1^*$..

Even if the effect of the parasitic impedance $L_E$ is compensated by the matching capacitor $C_{M1}$, the gain is reduced when the parasitic impedance $L_E$ is increased because of the imaginary part of $A_1^{\bullet}$. Nevertheless, the gain is relevantly larger than the gain of the amplifier of Figure 4 when the capacitor $C_{M1}$ compensates the inductance $L_E$.

For instance, by using a single down-bonding wire, with a parasitic inductance $L_E = 0.5$ nH, for grounding the emitter of the transistor $T_1$, the gain of the amplifier of Figure 4 is 3.4 dB while the gain of the amplifier of this invention is 15 dB.

Therefore the amplifier of the invention does not need large ground planes and thus the layout of the amplifier can be reduced.

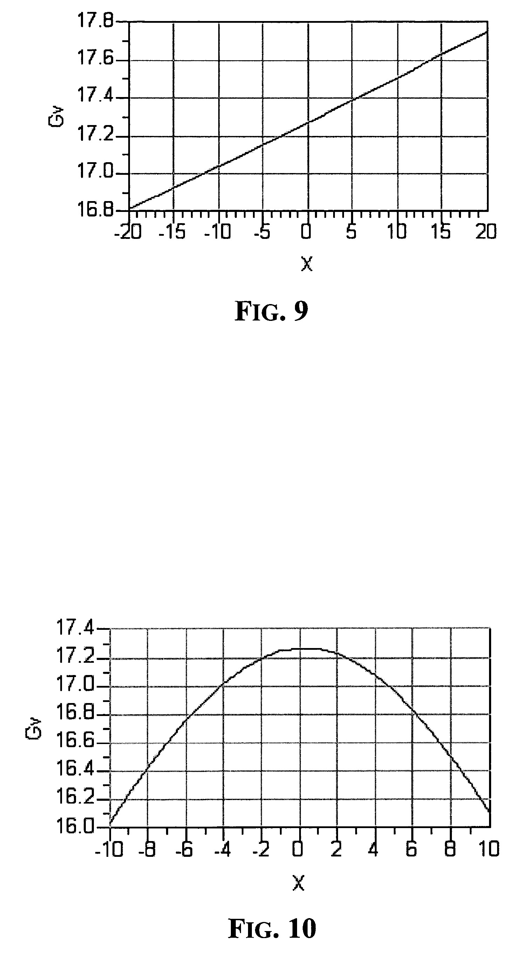

The amplifier of this invention is also less sensitive to fabrication spread and has a larger bandwidth. The frequency response of the amplifier of the invention is shown in Figure 8. It is possible to notice that the 3 dB band-pass, centered at a frequency $F_{RF}$ of 5350 MHz, is 800 MHz and the band-pass at 1 dB is about 400 MHz. Figure 9 is a diagram of gain variations $G_V$ in function of the percentage error X in determining the parasitic impedance $L_E$. Even with an error X of $\pm 20\%$, the gain $G_V$ undergoes to a variation of 1 dB only.

Figure 10 is a diagram that illustrates the sensitivity of the gain $G_V$ to percentage tolerances X in determining the matching capacitor $C_{M1}$. As it is possible to notice, even with an error X of $\pm 10\%$, the gain undergoes to a variation of 1 dB only.

By summarizing, the amplifier of this invention has a larger gain than the amplifier of Figure 4 having the same power consumption. Moreover it can be realized with a smaller layout because the gain is less sensitive than the amplifier of Figure 4 to the emitter parasitic inductance toward ground. Finally, the frequency response does not depend significantly from tolerances of the used components.

**Claims**

1. A common emitter single transistor ($T_1$) high frequency amplifier, having:

   an input inductance ($L_B$) between the base or gate of said transistor ($T_1$) and a high frequency input node on which a high frequency signal to be amplified is applied, and
   an output impedance matching network between the collector or drain of said transistor ($T_1$) and an output node of the amplifier on which an amplified signal is output,

   **characterized in that** the amplifier further comprises
   a matching capacitor ($C_{M1}$) connected between the emitter or source of the transistor ($T_1$) and said high frequency input node of the amplifier.

2. The amplifier of claim 1, wherein the inductance of said input inductor ($L_B$) and the capacitance of said matching capacitor ($C_{M1}$) are such to minimize the real part of the transfer function between the input high frequency signal and the intrinsic base-emitter or gate-source voltage ($V_\pi$) of the transistor of the amplifier.

3. The amplifier of claim 1, wherein the inductance of said input inductor ($L_B$) is larger than the inverse of the product between the squared angular frequency ($\omega^2$) of the high frequency input signal and the base-emitter or gate-source capacitance ($C_\pi$) of the transistor ($T_1$), and said matching capacitor ($C_{M1}$) has a capacitance such to nullify the real part of the transfer function between the input high frequency signal and the intrinsic base-emitter or gate-source voltage ($V_\pi$) of the transistor of the amplifier.

FIG. 1A

FIG. 1B

FIG. 2

**FIG. 3**

**FIG. 4**

**FIG. 5**

time, nsec

**FIG. 6**

**FIG. 7**

**FIG. 8**

FIG. 9

FIG. 10

**European Patent Office**

**EUROPEAN SEARCH REPORT**

Application Number

EP 04 42 5518

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 3 671 793 A (SCARLETT ROBERT M) 20 June 1972 (1972-06-20) * the whole document * ----- | 1-3 | H03F1/14 H03F1/56 |
| A | US 2001/045867 A1 (IWAI TAISUKE ET AL) 29 November 2001 (2001-11-29) * figures 1,6 * ----- | 1-3 | |

TECHNICAL FIELDS SEARCHED (Int.Cl.7)

H03F

The present search report has been drawn up for all claims

| Place of search | Date of completion of the search | Examiner |
|---|---|---|
| Munich | 6 December 2004 | Dietsche, S |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

............................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 04 42 5518

This annex lists the patent family members relating to the patent documents cited in the above-mentioned European search report.
The members are as contained in the European Patent Office EDP file on
The European Patent Office is in no way liable for these particulars which are merely given for the purpose of information.

06-12-2004

| Patent document cited in search report | | Publication date | Patent family member(s) | | Publication date |
|---|---|---|---|---|---|
| US 3671793 | A | 20-06-1972 | DE | 2044975 A1 | 23-03-1972 |
| | | | FR | 2061748 A7 | 25-06-1971 |
| | | | GB | 1271348 A | 19-04-1972 |
| | | | JP | 51024228 B | 22-07-1976 |
| | | | NL | 7013540 A ,B, | 18-03-1971 |
| US 2001045867 | A1 | 29-11-2001 | JP | 2001332935 A | 30-11-2001 |